(19) Europäisches Patentamt
European Patent Office
Office européen des brevets

(11) **EP 2 040 264 B1**

(12) **FASCICULE DE BREVET EUROPEEN**

(45) Date de publication et mention
de la délivrance du brevet:
**06.04.2011 Bulletin 2011/14**

(51) Int Cl.:
***G11C 7/14*** *(2006.01)*

(21) Numéro de dépôt: **08164774.5**

(22) Date de dépôt: **22.09.2008**

(54) **Mémoire SRAM à cellule de référence de polarisation**

S-RAM-Speicher mit magnetischer Vergleichszelle

SRAM memory with polarisation reference cell

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **24.09.2007 FR 0757792**

(43) Date de publication de la demande:
**25.03.2009 Bulletin 2009/13**

(73) Titulaire: **Commissariat à l'Énergie Atomique
et aux Énergies Alternatives
75015 Paris (FR)**

(72) Inventeur: **Thomas, Olivier
38420 Revel (FR)**

(74) Mandataire: **Ilgart, Jean-Christophe et al
BREVALEX
95 rue d'Amsterdam
75378 Paris Cedex 8 (FR)**

(56) Documents cités:
**FR-A- 2 898 432        US-A1- 2006 274 569
US-A1- 2007 189 060**

**Description**

**DOMAINE TECHNIQUE**

L'invention se rapporte au domaine des mémoires statiques à accès aléatoires SRAM (SRAM pour « static random access memory »), et concerne en particulier une structure de cellule mémoire SRAM, ainsi qu'une mémoire SRAM, amélioré(e)s. La présente invention prévoit en particulier une structure de cellule mémoire statique à accès aléatoire développée en technologie double-grille et dotée de transistors comportant deux grilles commandées indépendamment l'une de l'autre, dont les performances en termes de courant de lecture et de marge au bruit statique en lecture sont améliorées.

**ÉTAT DE LA TECHNIQUE ANTÉRIEURE**

Une cellule mémoire SRAM classique (SRAM pour « static random access memory » ou mémoire vive statique) comprend généralement deux inverseurs INV1, INV2, connectés selon une configuration dite de bascule ou « flip-flop » et deux transistors d'accès $TA_T$, $TA_F$ connectés à des lignes dites de bit $BL_T$ et $BL_F$, et commandés par une ligne de mot WL.
Les caractéristiques recherchées pour une cellule mémoire sont :

- une bonne stabilité lors des différentes opérations de lecture, d'écriture, de rétention, effectuées sur la cellule,
- un courant de conduction ou de charge le plus important possible pour donner à la cellule une vitesse de fonctionnement élevée,
- une taille de cellule minimale pour permettre de réaliser une mémoire avec une densité d'intégration de cellules importante,
- un courant en rétention le plus faible possible afin de minimiser la puissance consommée statique.

Ces critères sont contradictoires entre eux et amènent les concepteurs de mémoires à faire des compromis.
Les cellules SRAM à six transistors appelées « cellules 6T », offrent un bon compromis entre tous les critères précités.
En cherchant à réduire de plus en plus les tailles des transistors des cellules mémoires, les paramètres des transistors tels que leur largeur W de canal, leur longueur L de canal, leur tension de seuil $V_T$, leur perméabilité $\mu_0$, leur dopage Na, leur épaisseur d'oxyde de grille Tox fluctuent de plus en plus, comme indiqué dans les documents [TAK'01] et [YAM'04]. Cela entraîne une augmentation de la sensibilité des cellules mémoire face aux différentes sources de bruit telles que le couplage capacitif, le couplage inductif, le bruit d'alimentation, en raison des dispersions entre les transistors.
De nos jours, l'augmentation des dispersions entre les transistors impose de trouver de nouvelles cellules mémoires plus robustes avec un encombrement satisfaisant.
La stabilité d'une cellule peut être déterminée notamment par sa marge au bruit statique SNM en mode lecture, comme cela est présenté dans le document [SEE'87]. Lors d'un accès en lecture d'une cellule SRAM, le gain des inverseurs est diminué par la mise en conduction des transistors d'accès. Pour annuler cet effet, une cellule à 10 transistors, dans laquelle, lors d'un cycle de lecture, les noeuds de stockage et les lignes de bit sont découplés, a été proposée dans le document [CHA'01].
Une cellule mémoire à 8 transistors réalisée en technologie double grille ayant un fonctionnement similaire à celle comportant 10 transistors évoquée précédemment, a quant à elle été divulguée dans le document [KIM'05]. Malgré une forte amélioration de la marge au bruit statique SNM, les cellules à 10 transistors et à 8 transistors ont un encombrement très important par rapport aux cellules 6T.
Dans le document FR 2 898 432 une cellule mémoire 6T en technologie double grille est divulguée. Une telle cellule comporte des transistors d'accès commandés par deux lignes de mots activées indépendamment l'une de l'autre, dont la polarisation dépend du mode de fonctionnement (écriture, lecture ou rétention) dans lequel la cellule est placée. Cette cellule comporte une marge au bruit statique en lecture nettement améliorée par rapport aux cellules classiques, tout en présentant un encombrement satisfaisant. La limite d'une telle cellule est cependant un courant de lecture faible.
Le but de la présente invention est de trouver une nouvelle structure de cellule mémoire SRAM, présentant une bonne marge au bruit statique en lecture, tout en ayant des performances électriques en particulier en termes de courant de lecture améliorées.

**EXPOSÉ DE L'INVENTION**

L'invention concerne tout d'abord un dispositif microélectronique de mémoire vive à accès aléatoire, comprenant une pluralité de cellules comportant respectivement :

- une pluralité de transistors formant un bistable,
- un premier noeud de stockage et un deuxième noeud de stockage,
- un premier transistor double-grille d'accès au premier noeud de stockage et un deuxième transistor double-grille d'accès au deuxième noeud de stockage, une première grille du premier transistor d'accès et une première grille du deuxième transistor d'accès étant reliées à une première ligne de mot, une seconde grille du premier transistor d'accès et une seconde grille du deuxième transistor d'accès étant reliées à une deuxième ligne de mot,

le dispositif étant doté en outre : d'au moins une cellule mémoire de référence prévue pour délivrer un potentiel de polarisation prévu pour être appliqué à l'une des lignes de mot respective d'une ou plusieurs cellules données de ladite pluralité de cellules au moins lors d'accès en lecture desdits cellules données.

La valeur du potentiel de polarisation appliqué lors d'une opération de lecture peut être comprise entre les valeurs de potentiels de polarisation appliqués lors des opérations de rétention et d'écriture de la cellule.

La cellule de référence peut comporter : un premier noeud de stockage de référence et un deuxième noeud de stockage de référence, ledit potentiel de polarisation délivré par la cellule mémoire de référence étant dépendant d'un potentiel de référence prédéterminé.

La cellule de référence peut comporter : un premier noeud de stockage de référence et un deuxième noeud de stockage de référence, ledit potentiel de polarisation délivré par la cellule mémoire de référence étant dépendant d'un potentiel de référence prédéterminé et étant adapté en fonction des variations d'un potentiel du deuxième noeud de référence de la cellule de référence.

Le deuxième noeud de référence peut être par exemple un noeud destiné à stocker une information logique '0'.

Selon une possibilité de mise en oeuvre, la cellule de référence peut comporter : des moyens formant une boucle de rétroaction, en particulier négative, prévue pour diminuer le potentiel du deuxième noeud de référence de la cellule de référence suite à une augmentation de potentiel du deuxième noeud de référence.

Selon une possibilité de mise en oeuvre de la boucle de rétroaction, cette dernière peut comprendre des moyens réalisant un amplificateur opérationnel comportant :

- une entrée inverseuse connectée au deuxième noeud de la cellule de référence,
- une entrée non-inverseuse à laquelle le potentiel prédéterminé de référence est appliqué,
- une sortie délivrant ledit potentiel de polarisation.

La première ligne de mot peut être apte à être mise à une première valeur de potentiel, par exemple VSS, ou à une deuxième valeur de potentiel par exemple VDD, le potentiel de référence étant prévu de sorte que le potentiel de polarisation est supérieur à VSS et inférieur à VDD.

Selon une possibilité, la cellule de référence peut comporter en outre :

- une pluralité de transistors formant un bistable,
- un premier transistor double-grilles d'accès au premier noeud de référence et un deuxième transistor double-grille d'accès au deuxième noeud de référence,
- une première grille du premier transistor d'accès et une première grille du deuxième transistor d'accès étant reliées à une première ligne de mot, une seconde grille du premier transistor d'accès et une seconde grille du deuxième transistor d'accès étant reliées à une deuxième ligne de mot prévue pour délivrer ledit potentiel de polarisation.

La première ligne de mot de la cellule de référence peut être à un potentiel prévu pour assurer la conduction de transistors d'accès de la cellule de référence, tandis que le potentiel de polarisation donné est acheminé par la deuxième ligne de mot de la cellule de référence.

Selon une mise en oeuvre possible de la cellule de référence, cette dernière peut comporter une pluralité de transistors ayant un agencement identique à celui des transistors des cellules de ladite pluralité de cellules. Les transistors de la cellule de référence peuvent être identiques et avoir une taille identique à celle des transistors des autres cellules de la matrice.

La mémoire vive à accès aléatoire selon l'invention peut comprendre en outre :

- des moyens pour placer la première ligne de mot d'une ou plusieurs cellules, à un premier potentiel ou à un deuxième potentiel,
- des moyens pour placer la deuxième ligne de mot d'une ou plusieurs cellules, audit premier potentiel ou audit potentiel de polarisation donné.

Ledit potentiel de polarisation donné peut être destiné à être appliqué à l'une des lignes de mot respective d'une ou plusieurs cellules données de ladite pluralité de cellules lors d'accès en écriture desdits cellules données.
Selon une variante, la mémoire vive à accès aléatoire selon l'invention peut comprendre en outre :

- des moyens pour placer la première ligne de mot d'une ou plusieurs cellules, à un premier potentiel ou à un deuxième potentiel,
- des moyens pour placer la deuxième ligne de mot d'une ou plusieurs cellules, audit premier potentiel ou audit deuxième potentiel ou audit potentiel de polarisation donné.

Des potentiels de polarisation différents sont destinés à être appliqués à l'une des lignes de mot respective d'une ou plusieurs cellules données de ladite pluralité de cellules suivant que lesdites cellules données sont accédées en écriture, en lecture ou se trouvent en mode de rétention.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de cellule mémoire vive statique suivant l'art antérieur,
- la figure 2, illustre un exemple de caractéristique courant-tension d'un transistor double-grille,
- la figure 3, illustre un exemple de cellule mémoire suivant l'invention, dotée de 6 transistors double-grille et de deux lignes de mots,
- la figure 4, illustre un exemple de cellule mémoire de référence, prévue pour délivrer le potentiel appliqué à une ou plusieurs cellules mémoires données d'une mémoire SRAM suivant l'invention, lors d'une opération de lecture et éventuellement d'écriture sur ces cellules données,
- la figure 5 donne des courbes représentatives de paramètres caractéristiques d'une cellule mémoire de référence suivant l'invention, en fonction de l'évolution du potentiel du deuxième noeud de cette cellule,
- la figure 6 donne des courbes de produits normalisés d'un facteur de marge au bruit statique, élevé à une puissance donnée, et de courant de conduction de la cellule en lecture I_cell élevé à une autre puissance donnée,
- les figures 7A-7B donnent des courbes de produits d'un facteur de marge au bruit statique et de courant de conduction de la cellule en lecture I_cell élevé, respectivement, en fonction des variations de potentiel d'alimentation et en fonction des variations de procédés,
- la figure 8 illustre un exemple de matrice de cellules mémoires mise en oeuvre suivant l'invention, et comportant une cellule mémoire de référence, permettant de délivrer un potentiel à appliquer aux cellules mémoires sur lesquelles une opération de lecture et une opération d'écriture sont effectuées,
- la figure 9 illustre un autre exemple de matrice de cellules mémoires mise en oeuvre suivant l'invention, et comportant une cellule mémoire de référence.

Des parties identiques, similaires ou équivalentes des différentes figures portent les mêmes références numériques de façon à faciliter le passage d'une figure à l'autre.
Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

L'invention met en oeuvre une structure de mémoire à accès aléatoire (RAM) dotée de cellules comportant des transistors réalisés en technologie double grille, par exemple de type CMOS (CMOS pour « Complementary Metal Oxide Semi-conductor » ou « semiconducteur à oxyde de métal complémentaire »). Par « technologie double grille », on entend que ces transistors comportent deux grilles $G_1$, $G_2$ sous forme d'une première et d'une deuxième zone de matériau (x) de grille, réalisées de part et d'autre d'une zone active, et reliées ou connectées respectivement à des moyens de polarisation. Les deux zones de matériau(x) de grille peuvent être éventuellement distinctes ou disjointes l'une de l'autre et ne pas être connectées entre elles ou ne pas être reliées électriquement l'une à l'autre.
Une structure de cellule d'une mémoire à accès aléatoire suivant l'invention comprend un ensemble de transistors, par exemple des transistors d'accès, dotés de deux grilles électriquement indépendantes, ou qui ne sont pas connectées entre elles, et qui sont reliées respectivement à des premiers moyens de polarisation, et à des deuxièmes moyens de polarisation, distincts des premiers moyens de polarisation. Les premiers moyens de polarisation et les deuxièmes moyens de polarisation peuvent comprendre respectivement : une première ligne conductrice ou de connexion dite « première ligne de mot », apte à acheminer un potentiel de polarisation, et une deuxième ligne conductrice ou de connexion dite « deuxième ligne de mot », apte à acheminer un deuxième potentiel de polarisation. La cellule comprend également un autre ensemble de transistors, par exemple des transistors de conduction ou de charge, comportant une double grille formée de deux grilles reliées électriquement entre elles, ou connectées entre elles.

Les transistors de la cellule sont également mis en oeuvre de sorte que le courant entre le drain et la source Ids est susceptible d'adopter au moins 3 niveaux différents suivant la manière dont leurs 2 grilles sont polarisées respectivement.

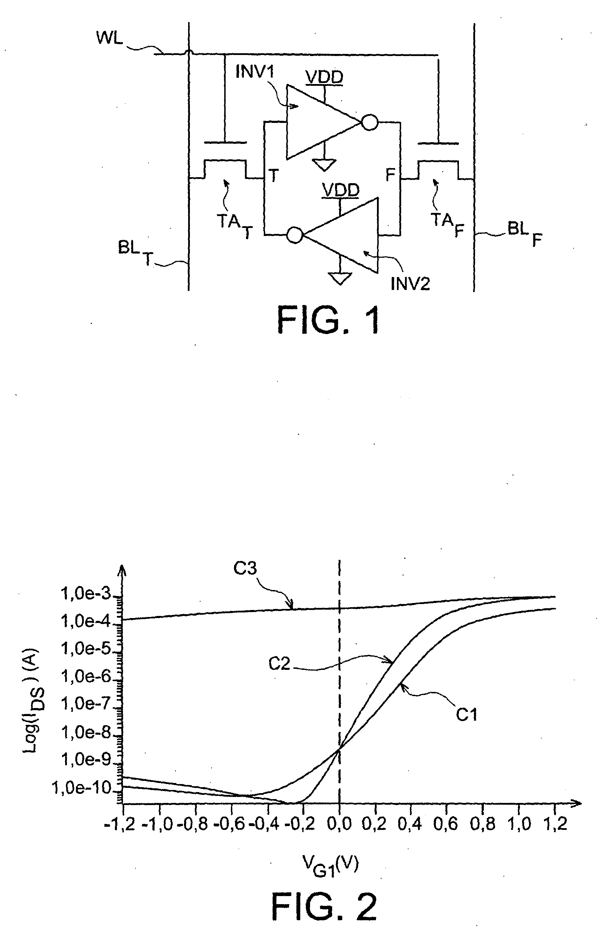

Des caractéristiques électriques d'un transistor double grille d'une cellule mémoire mise en oeuvre suivant l'invention, sont illustrées sur la figure 2B, sur laquelle trois courbes de polarisation $C_1$, $C_2$, $C_3$, sont données.

Sur cette figure, une première courbe de polarisation $C_1$ est représentative de l'évolution du courant drain-source Ids en fonction d'un potentiel Vg1 appliqué sur une première grille du transistor, lorsque la deuxième grille du transistor se trouve dans un premier état de polarisation et qu'un potentiel Vg2 = 0 Volt est appliqué sur la deuxième grille. La première courbe $C_1$ montre que pour une polarisation telle qu'un potentiel Vg2 = 0 Volt est appliqué sur la deuxième grille, on peut obtenir, le plus faible courant $I_{OFF}$ à l'état bloqué et le plus faible courant $I_{ON2}$ de saturation du transistor.

Une deuxième courbe de polarisation $C_2$ est représentative de l'évolution du courant drain-source Ids en fonction d'un potentiel Vg1 appliqué sur la première grille du transistor, lorsque la deuxième grille du transistor se trouve dans un deuxième état de polarisation et qu'un potentiel Vg2 = Vg1 est appliqué sur la deuxième grille. La deuxième courbe $C_2$ montre que pour une polarisation telle qu'un potentiel Vg2 = Vg1 est appliqué sur la deuxième grille, on peut atteindre le plus faible courant $I_{OFF}$ à l'état bloqué du transistor et le plus fort courant $I_{ON1}$ à l'état saturé. Une polarisation telle que Vg2 = Vg1 peut permettre d'obtenir le plus important rapport $I_{ON}/I_{OFF}$ du courant à l'état saturé sur le courant à l'état bloqué.

Une troisième courbe de polarisation $C_3$ est représentative de l'évolution du courant drain-source Ids en fonction d'un potentiel Vg1, appliqué sur la première grille du transistor, lorsque la deuxième grille du transistor se trouve dans un troisième état de polarisation et qu'un potentiel Vg2 = VDD, avec VDD un potentiel d'alimentation de la cellule, est appliqué sur la deuxième grille. Pour le troisième état de polarisation tel que Vg2 = VDD, on peut obtenir, lorsque Vg1 = VDD, le plus fort courant $I_{ON1}$ de saturation du transistor et, lorsque Vg1 = 0 Volt, le plus faible courant $I_{ON2}$ de saturation du transistor.

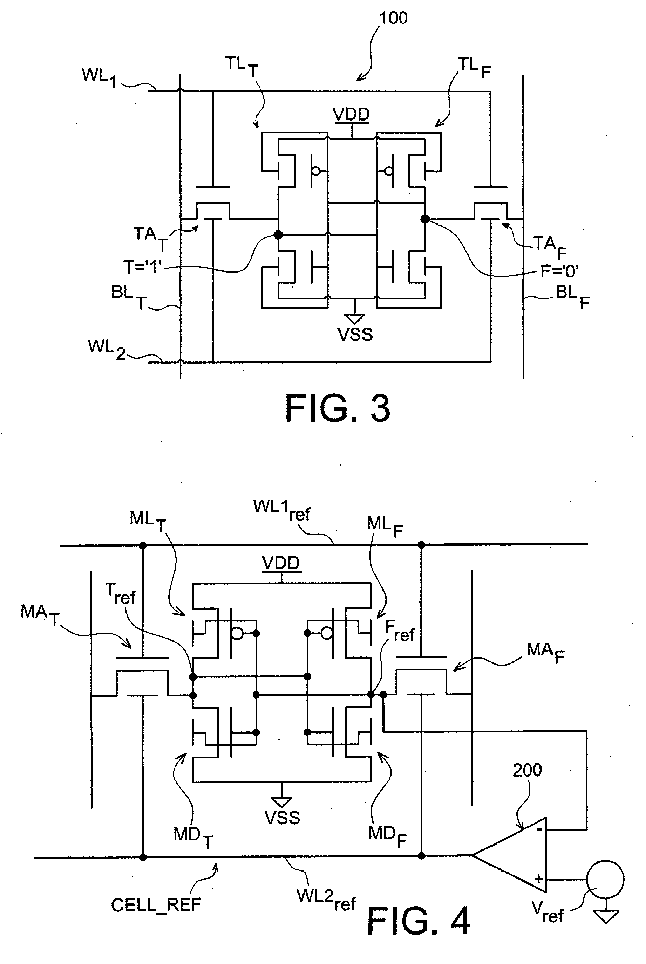

Un exemple de cellule mémoire ou d'un point mémoire, intégré à une mémoire SRAM suivant l'invention, est illustrée sur la figure 3. Cette cellule 100, est une cellule dite « 6T », dotée de 6 transistors réalisés par exemple en technologie MOS (MOS pour « Métal Oxide Semi-conductor » ou « semiconducteur à oxyde de métal ») double-grille.

La cellule 100 comprend un premier transistor de charge à double grille $TL_T$, ainsi qu'un deuxième transistor de charge à double grille $TL_F$. Les transistors de charge $TL_T$ et $TL_F$, peuvent être réalisés dans un premier type de technologie MOS donnée, par exemple une technologie de type PMOS. Les deux grilles du premier transistor de charge à double grille $TL_T$ sont connectées ensemble, tandis que les deux grilles du deuxième transistor de charge à double grille $TL_F$ sont également connectées ensemble. La double grille du deuxième transistor de charge $TL_F$ est également reliée à un premier noeud de stockage T de la cellule 100, tandis que la double grille du premier transistor de charge $TL_T$ est reliée à un deuxième noeud de stockage F de la cellule 100. Les sources des transistors de charge $TL_T$, $TL_F$ sont connectées entre elles et à un potentiel d'alimentation VDD, qui peut être par exemple de l'ordre de 1,2 Volt pour des grilles de dimension critique de l'ordre de 40 nanomètres.

Le drain du premier transistor de charge $TL_T$ et le drain du deuxième transistor de charge $TL_F$, sont reliés respectivement au premier noeud de stockage T de la cellule 100 et au deuxième noeud de stockage F de la cellule 100. La cellule 100 comprend également un premier transistor de conduction à double grille $TD_T$, ainsi qu'un deuxième transistor de conduction à double grille $TD_F$. Les transistors de conduction $TD_T$ et $TD_F$, peuvent être réalisés dans un type de technologie MOS complémentaire dudit premier type, par exemple une technologie NMOS. Les deux grilles du premier transistor de conduction $TD_T$ sont connectées ensemble, tandis que les deux grilles du deuxième transistor de conduction $TD_F$ sont également connectées ensemble. La double grille du premier transistor de conduction $TD_T$ est également reliée au deuxième noeud de stockage F, tandis que la double grille du deuxième transistor de conduction $TD_F$ est connectée au premier noeud de stockage T de la cellule 100. Les sources des transistors de conduction $TD_T$, $TD_F$ sont connectées entre elles et à un potentiel VSS. Le potentiel VSS peut être par exemple de l'ordre de 0 Volt. Le drain du deuxième transistor de conduction $TD_F$ et le drain du premier transistor de conduction $TD_T$ sont reliés respectivement au deuxième noeud de stockage F de la cellule 100 et au premier noeud de stockage T de la cellule 100.

Les transistors de charge $TL_T$, $TL_F$ et de conduction $TD_T$, $TD_F$ forment un bistable pour la cellule 100, et sont prévus pour contrôler et maintenir une information gardée par les noeuds de stockage T, F. Le premier noeud de stockage T, peut être destiné à conserver une information logique donnée, par exemple un '1' logique, tandis que le deuxième noeud de stockage F est destiné à garder une information logique complémentaire de l'information logique, par exemple un '0' logique.

La cellule 100 est également dotée d'un premier transistor d'accès $TA_T$ à double grille et d'un deuxième transistor d'accès $TA_F$ à double grille, par exemple de type NMOS. Le premier transistor d'accès $TA_T$ comporte une grille reliée à une première ligne de mot $WL_1$ et une autre grille reliée à une deuxième ligne de mot $WL_2$. La première ligne de mot $WL_1$ et la deuxième ligne de mot $WL_2$ sont destinées respectivement, à acheminer un premier potentiel de polarisation et un deuxième potentiel de polarisation, permettant de commander l'accès à la cellule. La manière dont les lignes de mot $WL_1$ et $WL_2$ sont polarisées respectivement, détermine les différentes phases de fonctionnement de la cellule 100 : de lecture, d'écriture, et de rétention.

Le deuxième transistor d'accès $TA_F$ est également doté d'une grille reliée à la première ligne de mot $WL_1$ et d'une deuxième grille reliée à la deuxième ligne de mot $WL_2$. La source du premier transistor d'accès $TA_T$ est reliée à une première ligne de bit $BL_T$, tandis que la source du deuxième transistor d'accès $TA_F$ est reliée à une deuxième ligne de bit $BL_F$. Les lignes de bits $BL_T$ et $BL_F$ sont susceptibles notamment de transmettre des données à écrire dans la cellule. Le drain du premier transistor d'accès $TA_T$ est relié au premier noeud T, tandis que le drain du deuxième transistor d'accès $TA_F$ est relié au deuxième noeud F. Les transistors d'accès $TA_T$, $TA_F$, sont agencés pour permettre d'accéder aux noeuds de stockage T et F, lors d'une phase de lecture ou d'écriture de la cellule 100, et bloquer l'accès de la cellule 100, lorsque la cellule 100 est dans un mode de rétention d'information.

Dans cet exemple, la première ligne de mot $WL_1$ est prévue pour acheminer un premier potentiel de polarisation qui est susceptible d'adopter 2 états, un état correspondant par exemple à une première valeur de potentiel, par exemple Vss et un deuxième état correspondant par exemple à une deuxième valeur de potentiel VDD, suivant que la cellule est mise dans un mode de lecture, d'écriture, ou de rétention.

La deuxième ligne de mot $WL_2$ est prévue pour acheminer un deuxième potentiel de polarisation qui est susceptible d'adopter au moins 2 états suivant que la cellule est mise dans un mode de rétention, de lecture, ou d'écriture un premier état correspondant par exemple à une première valeur de potentiel, par exemple VSS. La deuxième ligne de mot $WL_2$ est également susceptible d'être mise à un potentiel $V_{WL2ref}$ adaptable ou modulable, et intermédiaire entre la première valeur de potentiel, par exemple Vss et une deuxième valeur de potentiel, par exemple VDD. La deuxième ligne de mot $WL_2$ est ainsi susceptible d'adopter plusieurs états intermédiaires entre le premier état et le deuxième état, correspondant par exemple à plusieurs valeurs intermédiaires de potentiel comprises entre VSS et VDD, lorsque la cellule est mise dans un mode de lecture.

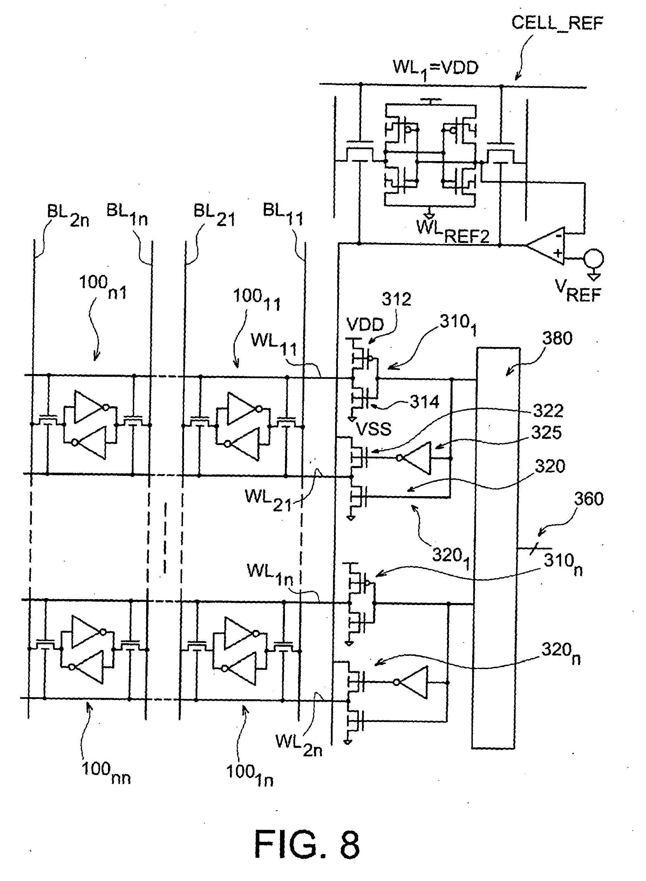

Selon une possibilité de mise en oeuvre (figure 8), la deuxième ligne de mot $WL_2$ est également mise au potentiel $V_{WL2ref}$ adaptable ou modulable, et intermédiaire entre la première valeur de potentiel, par exemple VSS et une deuxième valeur de potentiel, par exemple VDD, lorsque la cellule est mise dans un mode d'écriture.

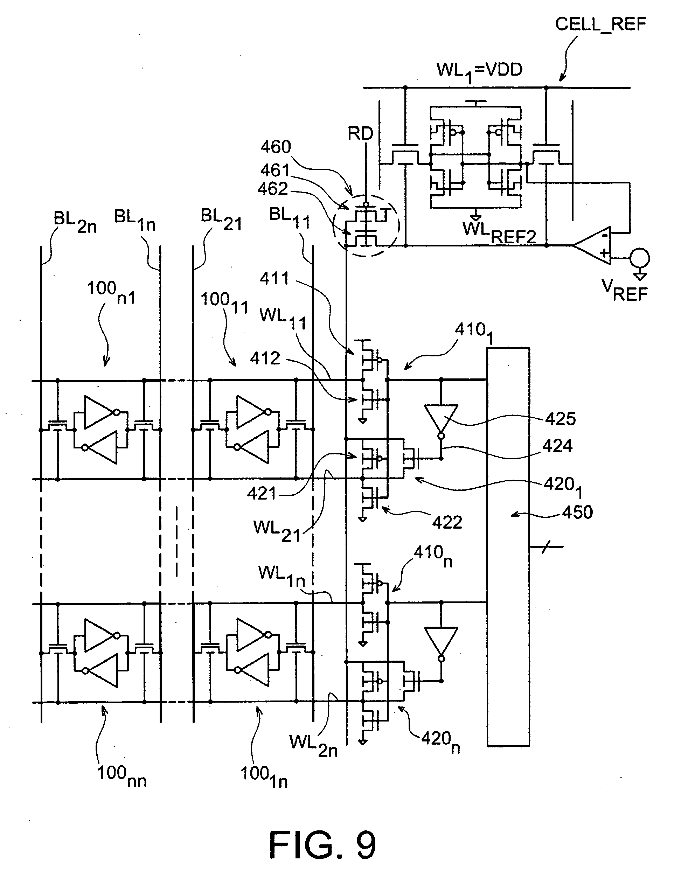

Selon une variante (figure 9), la deuxième ligne de mot $WL_2$ est susceptible d'adopter un autre état correspondant par exemple à la deuxième valeur de potentiel, par exemple VDD, lorsque la cellule est mise dans un mode d'écriture.

Dans l'exemple de cellule illustrée sur la figure 3, en mode de rétention, les lignes de mots $WL_1$ et $WL_2$ sont mises respectivement à un potentiel prévu pour bloquer l'accès aux noeuds de stockage, par exemple au potentiel VSS.

En mode écriture, les deux lignes de mots $WL_1$ et $WL_2$ sont prévues pour activer les transistors d'accès et générer un courant de conduction $I_{CELL}$ permettant de faire commuter la cellule 100, avec une différence de potentiel entre les lignes de bit $BL_T$ et $BL_F$ de préférence la plus faible possible. Pour cela, les deux lignes de mots $WL_1$ et $WL_2$ peuvent être polarisées par exemple à VDD ou selon la variante évoquée plus haut, la première ligne de mot $WL_1$ est polarisée par exemple à VDD, tandis que la deuxième ligne de mot $WL_2$ est mise au potentiel $V_{WL2ref}$ adaptable ou modulable, et VSS et VDD.

L'utilisation de transistors d'architecture double grille favorise la réalisation de la condition précitée dans la mesure où, compte tenu des conditions de polarisation, les transistors d'accès $TA_T$, $TA_F$ seront dotés de deux canaux délivrant un courant élevé.

En mode lecture, le compromis performance-stabilité des cellules de la mémoire suivant l'invention est amélioré à l'aide d'un circuit de référence, susceptible d'imposer pour ce mode de lecture, un potentiel VWL2ref appliqué sur une des deux lignes de mot, par exemple sur la deuxième ligne de mot WL2. La première ligne de mot WL1 est polarisée à un potentiel permettant de mettre en conduction les transistors d'accès $TA_T$ et $TA_F$, par exemple VDD.

La valeur du potentiel de polarisation VWL2ref appliqué sur la deuxième ligne de mot d'une cellule lors d'une opération de lecture sur cette cellule, est comprise entre les valeurs des potentiels de polarisation appliqués lors des opérations de rétention et d'écriture, et peut être adaptée de manière à privilégier le meilleur compromis entre stabilité et performances électriques de la cellule.

Le potentiel VWL2ref peut être auto-adaptable ou auto-ajustable. Par « auto-adaptable » ou « auto-ajustable », on entend qu'il est susceptible d'être modulé à l'aide d'une boucle de rétroaction.

Le potentiel VWL2ref est susceptible d'être adapté, en fonction des variations du potentiel d'un noeud du circuit de référence, qui sert de noeud référence. Le circuit de référence peut jouer le rôle de circuit témoin, en particulier de variations environnementales, par exemple de température et celles de la tension d'alimentation, et qui sont susceptibles également d'influer sur les autres cellules de la mémoire. La valeur du potentiel VWL2ref dépend elle-même d'un potentiel prédéterminé de référence Vref. Le potentiel de référence Vref peut avoir été prédéterminé par exemple en fonction d'un compromis entre des critères de stabilité et de performances électriques souhaités, par ailleurs en fonction du meilleur compromis entre stabilité en lecture SNM et courant de conduction Icell. Le circuit de référence peut être une cellule mémoire de référence.

La figure 4 illustre un exemple de circuit de référence, prévu pour délivrer le potentiel VWL2ref que la deuxième ligne de mot d'une ou des cellule(s) sur laquelle ou sur lesquelles un accès en lecture est réalisé, achemine(nt). Ce circuit de référence est sous forme d'un point mémoire de référence ou d'une cellule mémoire de référence noté CELL_ REF, ayant un agencement semblable à celui de la cellule 100. Les transistors de la cellule de référence peuvent être identiques à ceux des autres cellules.

La cellule de référence CELL_REF comprend un premier transistor de charge à double grille $ML_T$, un deuxième transistor de charge à double grille $ML_F$, un premier transistor de conduction à double grille $MD_T$, un deuxième transistor de conduction à double grille $MD_F$. Les transistors $ML_T$, $ML_F$, $MD_T$, $MD_F$, forment un bistable, et sont prévus pour contrôler et maintenir une information gardée par des noeuds de stockage de référence $T_{ref}$, $F_{ref}$, le premier noeud de stockage $T_{ref}$ de référence étant par exemple destiné à conserver une information logique '1', tandis que le deuxième noeud de stockage $F_{ref}$ de référence est destiné à garder une information logique '0'.

La cellule mémoire de référence CELL_REF est également dotée d'un premier transistor d'accès $MA_T$ à double grille et d'un deuxième transistor d'accès $MA_F$ à double grille. La cellule de référence CELL_REF comporte également une première ligne de mot $WL_{1ref}$ et une deuxième ligne de mot $WL_{2ref}$.

La cellule mémoire de référence CELL_REF est dotée de lignes de bits BLTref, BLFref qui peuvent être polarisées à une tension équivalente à une tension dite « de précharge » des lignes de bits des cellules de la matrice ou éventuellement à une tension supérieure à cette tension de précharge, en particulier dans un cas où la tension de précharge est inférieure à la tension d'alimentation VDD.

La tension de précharge correspond dans ce cas au potentiel le plus élevé susceptible d'être appliqué sur les lignes de bit d'une cellule, lors des différentes phases de fonctionnement de cette dernière.

Une polarisation des lignes de bits de la cellule de référence à la tension de précharge, peut éventuellement être appliquée en continu sur les lignes de bits BLTref et BLFref de manière à simuler un cas de fonctionnement qui correspond par exemple à celui dans lequel les lignes de bits BLT et BLF d'une cellule, sont polarisées comme lors d'un début d'un cycle de lecture.

La boucle de rétroaction peut être mise en oeuvre à l'aide de moyens formant un amplificateur opérationnel 200 dont la borne inverseuse est connectée au deuxième noeud de référence $F_{ref}$ et comportant une borne non-inverseuse sur laquelle est appliqué le potentiel de référence prédéterminé Vref.

La sortie de l'amplificateur opérationnel 200 est reliée à la deuxième ligne de mot $WL_{2ref}$ de la cellule de référence CELL_REF, et délivre ainsi le potentiel VWL2ref qui s'adapte en fonction des variations du potentiel du deuxième noeud $F_{ref}$ de référence de la cellule CELL_REF. La sortie de l'amplificateur opérationnel 200 est également reliée respectivement à une grille des transistors d'accès $MA_T$ et $MA_T$. Le potentiel VWL2REF est proportionnel à la différence de tension entre le potentiel de référence prédéterminé Vref et le potentiel du deuxième noeud $F_{ref}$, de sorte que VWL2ref=(VREF-V(F))*G avec G le gain de l'amplificateur. L'amplificateur peut être alimenté entre 0V et VDD. Si V(F) > VREF alors VWL2REF=VSATmin (avec VSATmin~50mV). Si V(F)<VREF alors VSATmin< VWL2REF < VSATmax (avec VSATmax = VDD-100mV ).

La boucle de rétroaction permet de limiter l'augmentation du potentiel du noeud de référence $F_{ref}$, dans la mesure où, lorsque le potentiel du noeud de référence $F_{réf}$ augmente, la conduction du transistor $TA_F$ est diminuée par la diminution du potentiel VWL2ref appliqué sur la deuxième ligne de mot WL2ref de la cellule de référence, ce qui a tendance à faire diminuer le potentiel du noeud de référence $F_{ref}$ (diminue la quantité de charges injectées en $F_{ref}$ par le transistor $TA_F$). Le potentiel du noeud de référence $F_{ref}$ a ainsi tendance à se maintenir à un potentiel inférieur au potentiel de référence Vref prédéterminé. La boucle de rétroaction permet de mettre en oeuvre un système autorégulé permettant de garantir le retour du potentiel F à une valeur donnée, suite à des variations de ce potentiel, dues par exemple à des facteurs environnementaux par exemple de variation de température ou de variation de tension d'alimentation.

Le potentiel VWL2ref de la deuxième ligne de mot WL2ref de la cellule de référence est appliqué aux cellules sur lesquelles une opération de lecture est effectuée. Pour le mode de rétention, la deuxième ligne de mot WL2ref de la cellule de référence CELL_REF est isolée. Selon une possibilité de mise en oeuvre (figure 8), le potentiel VWL2ref de la deuxième ligne de mot WL2ref de la cellule de référence peut être également appliqué aux cellules sur lesquelles une opération d'écriture est effectuée.

La mise en oeuvre de la cellule de référence CELL_REF permet de maintenir la tension du noeud F des cellules sur lesquelles on réalise un accès en lecture en dessous d'un seuil prédéterminé, en fonction du compromis performance - stabilité souhaité.

Le choix de la tension de référence Vref peut être déterminé à partir d'un compromis, entre marge au bruit statique SNM et valeur du courant de conduction de la cellule Icell_rd lors d'une opération de lecture. Un tel compromis peut être déterminé à l'aide d'une relation entre marge au bruit statique SNM par exemple à l'aide du produit entre la marge au bruit statique SNM et celui du courant de conduction de la cellule Icell_rd mesuré pour différentes valeurs de potentiel au noeud de référence $F_{ref}$.

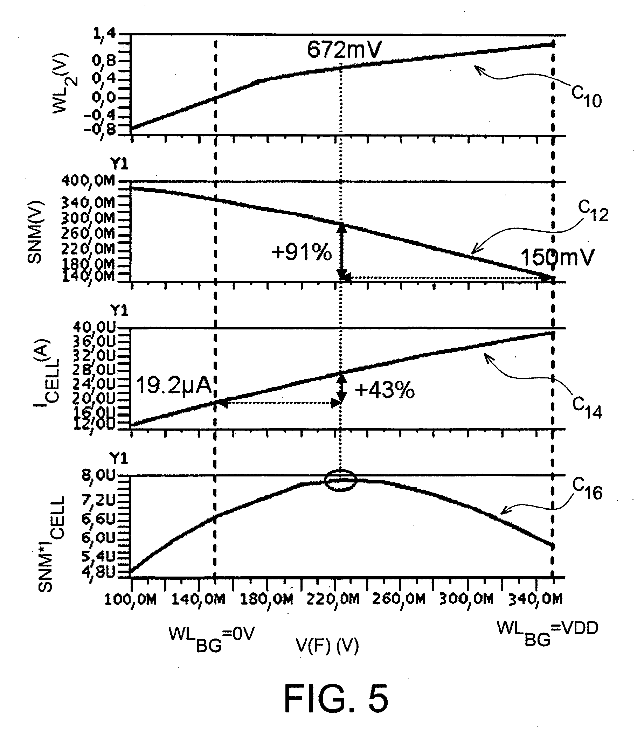

La figure 5 illustre des exemples de courbes $C_{10}$, $C_{12}$, $C_{14}$, $C_{16}$ représentatives respectivement, du produit Icell\*SNM, du courant de conduction Icell, de la stabilité en lecture SNM, et du potentiel VWL2 susceptible d'être appliqué sur la ligne de mot, chacun en fonction du potentiel du noeud de référence $F_{ref}$.

Avec l'augmentation du potentiel F la marge au bruit statique SNM diminue (courbe $C_{12}$ décroissante) et $I_{CELL}$ augmente (courbe $C_{14}$ croissante). Le produit des deux caractéristiques (courbe C16) donne un optimum (point C161 de la courbe C16) qui correspond au meilleur compromis entre stabilité et performance. Dans cet exemple, l'optimum correspond à un potentiel F par exemple de 220 mV pour un potentiel $VWL_2$ utile de 672 mV. Comparés à des points de polarisation extrêmes si $VWL_2$ était égal à Vss = 0 Volt et si $VWL_2$ était égal à VDD = 1,2 Volt, la marge au bruit statique SNM est augmentée 91 % et $I_{CELL}$ de 43% lorsque l'on choisit l'optimum $C_{161}$ de la courbe C16.

Selon une variante, le choix du potentiel de référence Vref peut être effectué en privilégiant l'un des deux critères de stabilité en lecture SNM et courant de conduction Icell_rd en lecture.

Par exemple, on peut privilégier le critère de stabilité en lecture SNM par rapport au courant de conduction Icell, en choisissant le potentiel de référence Vref en déterminant l'optimum d'un produit Icell_rd\*SNM[2].

Selon un autre exemple, on peut privilégier le courant de conduction Icell par rapport au critère de stabilité en lecture SNM, en choisissant le potentiel de référence Vref en déterminant l'optimum d'un produit Icell_rd[2]\*SNM.

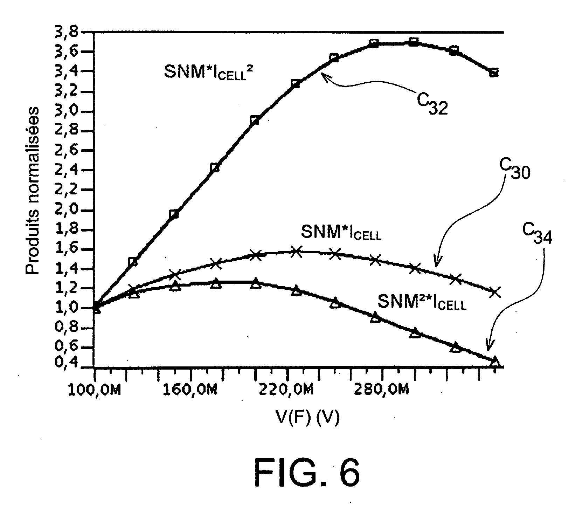

La figure 6 illustre des exemples de courbes $C_{30}$, $C_{32}$, $C_{34}$, représentatives respectivement, d'un produit Icell_rd\*SNM, d'un produit Icell_rd\*SNM[2], du produit (Icell_rd)[2]\*SNM, et du potentiel VWL2ref susceptible d'être appliqué sur la deuxième ligne de mot des cellules accédés en lecture, chacun en fonction du potentiel du deuxième noeud.

Le tableau ci-dessous donne une comparaison entre les caractéristiques électriques de la cellule 100, avec un système de contre réaction à celles respectivement d'une cellule notée 6T-2WL semblable, en technologie double-grille et qui ne serait pas associée à une contre-réaction, et à celles d'une cellule SRAM standard à grille commune notée 6T-DG. La colonne notée « 100\* » correspond aux performances de la cellule 100 à laquelle on appliquerait également le potentiel VWL2ref lors d'opérations d'écriture.

Les résultats ont été obtenus pour une technologie de grille de dimension de l'ordre de 40 nm, avec des transistors de taille telle que W = 76 nm, et L = 40 nm.

Le facteur NBL, caractérise le nombre de cellules par ligne bit, calculé par rapport à un courant de fuite des transistors d'accès $I_{PG}$ et au courant de conduction de la cellule en mode lecture ($I_{CELL\_RD}$), tel que :

$$NBL = \frac{I_{CELL}}{I_{PG}} > x \cdot lignes$$

Ce facteur doit être de préférence supérieur à x fois le nombre de lignes de mot, où x est un facteur de marge habituellement compris entre 5 et 10. $I_{CELL\_WR}$ donne le courant de conduction de la cellule en écriture. Le comportement de la cellule par rapport aux cycles de lecture et d'écriture est déterminé de façon respective par la marge au bruit statique SNM et la marge en écriture WM.

Les résultats ont été obtenus dans des conditions typiques 27°C, une alimentation de l'ordre de 1,2 V.

Pour un dimensionnement minimal des transistors et dans des conditions de simulations typiques, la cellule 6T-DG présente une SNM particulièrement faible qui peut être de l'ordre de 67 mV et la cellule 6T-2WL le courant de lecture et le facteur NBL les plus faibles.

La cellule 100 présente le meilleur compromis marge au bruit statique performances électriques.

| Cellules | 6T-DG | 6T-2WL | 100 | 100* |
|---|---|---|---|---|
| $I_{OFF}$ (pA) | 674 | 674 | 674 | 674 |
| $I_{PG}$ (pA) | | 268 | | |
| $I_{CELL\_RD}$ (µA) | 38,6 | 19,1 | 27,5 | 27,5 |
| $I_{CELL\_WR}$ (µA) | | 38.6 | 27,5 | 38, 6 |
| NBL (x10[3]) | 144 | 71 | 102 | 102 |
| SNM (mV) | 67 | 351 | 285 | 285 |
| WM (mV) | | 571 | 271 | 571 |

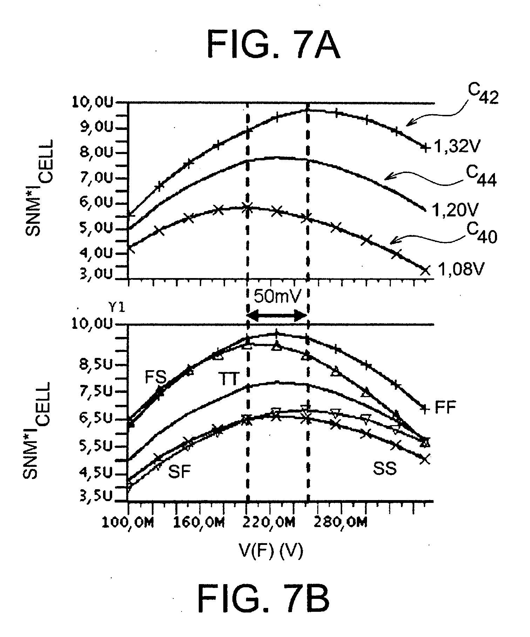

La figure 7A montre les variations de l'optimum entre la marge au bruit statique SNM et le courant de conduction $I_{CELL\_rd}$ de la cellule 100, pour diverses valeurs de tensions d'alimentation. Sur cette figure :

- la courbe $C_{40}$ est représentative d'un produit Icell*SNM mesuré sur la cellule 100, pour une tension d'alimentation de 1,08 Volts,
- la courbe $C_{42}$ est représentative respectivement, du produit Icell*SNM mesuré sur la cellule 100, pour une tension d'alimentation de 1,20 Volt,
- la courbe $C_{44}$ est représentative respectivement, du produit Icell*SNM mesuré sur la cellule 100, pour une tension d'alimentation de 1,32 Volt.

La figure 7B montre quant à elle les variations de l'optimum entre la marge au bruit statique SNM et le courant de conduction $I_{CELL}$ de la cellule 100, pour des fluctuations du procédé de fabrication. La faible variation de l'optimum sur les figures 7A et 7B montre une bonne tolérance d'un exemple de mémoire conçue selon l'invention aux variations de tension d'alimentation et de procédé de fabrication.

Sur la figure 8, un exemple de mémoire SRAM dotée d'une pluralité de n*n cellules $100_{11}$, ..., $100_{1n}$, ..., $100_{n1}$, ..., $100_{nn}$ telle que la cellule 100 précédemment décrite en liaison avec la figure 3, est représentée. La mémoire est également dotée d'une cellule mémoire de référence telle que la cellule cell_REF précédemment décrite en liaison avec la figure 4.

Chaque rangée de mémoire peut être associée à des premiers moyens de commutation et à des deuxièmes moyens de commutation.

Les cellules $100_{11}$, ..., $100_{1n}$ d'une même rangée partagent une même première ligne de mot $WL_{11}$ et une même deuxième ligne de mot $WL_{21}$ et sont associées à des premiers moyens de commutation $310_1$ prévus pour connecter la première ligne de mot $WL_{11}$ à un premier potentiel, par exemple égal à VDD ou à un deuxième potentiel VSS, selon que l'on réalise un accès en lecture, en écriture, ou que l'on est dans un mode de rétention. La première ligne de mot $WL_{11}$ est ainsi susceptible d'adopter deux états ou deux valeurs de potentiels VDD et VSS différents.

Les cellules $100_{11}$, ..., $100_{1n}$ d'une même rangée sont également associées à des deuxièmes moyens de commutation $320_1$ prévus pour connecter la deuxième ligne de mot $WL_{21}$ à la deuxième ligne de mot WLref2 de la cellule de référence, lorsque l'on réalise un accès en lecture ou en écriture sur une ou plusieurs cellules de ladite rangée, ou à connecter la deuxième ligne de mot $WL_{21}$ à un deuxième potentiel, par exemple égal à VSS lorsque les cellules de la rangée sont en mode de rétention. La matrice de cellules peut également comprendre un décodeur 350 et un bus d'adresse, dédiés à la sélection des lignes de mot et à faire commuter les moyens de commutation $310_1$, $320_1$, $310_n$, $320_n$.

Les premiers moyens de commutation $310_1$ $310_n$ peuvent être prévus par exemple sous forme de deux transistors 312, 314 double grille connectés entre VDD et VSS et formant un inverseur CMOS en sortie du décodeur 350.

Les deuxièmes moyens de commutation $320_1$ $320_n$ peuvent comprendre par exemple deux transistors 322, 324 double grille à grilles communes et sources communes, un des transistors ayant une électrode connectée à la deuxième ligne de mot de la cellule de référence CELL REF, ainsi qu'un inverseur 325 situé en sortie du décodeur 350 et connecté aux grilles du transistor 322.

Dans ce dispositif, chaque rangée de mémoire peut être associée à des premiers moyens de commutation et à des deuxièmes moyens de commutation.

Les cellules $100_{11}$,..., $100_{1n}$ d'une même rangée partagent une même première ligne de mot $WL_{11}$ et une même deuxième ligne de mot $WL_{21}$ et sont associées à des premiers moyens de commutation $310_1$ susceptibles de connecter la première ligne de mot $WL_{11}$ à un premier potentiel, par exemple égal à VDD ou à un deuxième potentiel VSS, selon que l'on réalise un accès en lecture, en écriture, ou que l'on est dans un mode de rétention. La première ligne de mot $WL_{11}$ est ainsi susceptible d'adopter deux états ou deux valeurs de potentiels VDD et VSS différents.

Les cellules $100_{11}$,..., $100_{1n}$ d'une même rangée sont également associées à des deuxièmes moyens de commutation $320_1$ aptes à connecter la deuxième ligne de mot $WL_{21}$ à la deuxième ligne de mot WLref2 de la cellule de référence, lorsque l'on réalise un accès en lecture ou en écriture sur une ou plusieurs cellules de ladite rangée, ou à connecter la deuxième ligne de mot $WL_{21}$ à un deuxième potentiel, par exemple égal à VSS lorsque les cellules de la rangée sont en mode de rétention. La matrice de cellules peut également comprendre un décodeur 350 et un bus d'adresse, dédiés à la sélection des lignes de mot et à faire commuter les moyens de commutation $310_1$, $320_1$, $310_n$, $320_n$.

Sur la figure 9, un autre exemple de mémoire SRAM dotée d'une pluralité de n*n cellules $100_{11}$,..., $100_{1n}$,..., $100_{n1}$, ..., $100_{nn}$ et d'une cellule mémoire de référence telle que la cellule cell_REF, est donnée.

Les cellules $100_{11}$, ..., $100_{1n}$ d'une même rangée partagent une même première ligne de mot $WL_{11}$ et une même deuxième ligne de mot $WL_{21}$ et sont associées à des premiers moyens de commutation $410_1$ susceptibles de connecter la première ligne de mot $WL_{11}$ à un premier potentiel, par exemple égal à VDD ou à un deuxième potentiel VSS, selon que l'on réalise un accès en lecture, en écriture, ou que l'on est dans un mode de rétention. La première ligne de mot $WL_{11}$ est ainsi susceptible d'adopter deux états ou deux valeurs de potentiels VDD et VSS différents.

Les premiers moyens de commutation $410_1$ $410_n$ peuvent comprendre par exemple deux transistors 412, 414 double grille connectés entre VDD et VSS et formant un inverseur CMOS en sortie d'un décodeur 450 de ligne.

Les cellules $100_{11}$, ..., $100_{1n}$ d'une même rangée sont également associées à des deuxièmes moyens de commutation $420_1$ aptes à connecter la deuxième ligne de mot $WL_{21}$ à la deuxième ligne de mot WLref2 de la cellule de référence, lorsque l'on réalise un accès en lecture sur une ou plusieurs cellules de ladite rangée, à connecter la deuxième ligne de mot $WL_{21}$ à un deuxième potentiel, par exemple égal à VSS lorsque les cellules de la rangée sont en mode de rétention, et à connecter la deuxième ligne de mot $WL_{21}$ à un potentiel VDD, lorsque l'on réalise un accès écriture sur une ou plusieurs cellules de ladite rangée.

Dans cet exemple la tension appliquée sur la deuxième ligne de mot est différente suivant que l'on se trouve en mode de lecture ou d'écriture. La deuxième ligne de mot $WL_2$ est susceptible d'adopter un état correspondant par exemple à la deuxième valeur de potentiel, par exemple VDD, lorsque la cellule est mise dans un mode d'écriture.

Pour cela, les deuxièmes moyens de commutation $420_1$ $420_n$ comprennent des moyens 460 actionnés par un signal RD d'indication de phase de lecture, et prévus pour délivrer un potentiel égal à VDD lorsque le signal d'indication de lecture est inactif, par exemple égal à 0 V et délivrer le potentiel de la deuxième ligne de mot WL2ref de la cellule de référence CELL_REF, lorsque le signal d'indication d'opération de lecture RD est actif, par exemple égal à VDD. Les moyens 460 peuvent être par exemple sous forme de 2 transistors double-grille 461, 462, dont les grilles sont commandées par le signal d'indication d'opération de lecture RD.

Les deuxièmes moyens de commutation $420_1$, ..., $420_n$ peuvent comprendre également des transistors 421, 422 double-grilles agencées en inverseur CMOS et dont les grilles sont connectées à celles des transistors 411, 412 des premiers moyens commutateurs.

Les deuxièmes moyens de commutation $420_1$, ..., $420_n$ peuvent comprendre également un transistor double-grille interrupteur 424 susceptible de connecter l'entrée de l'inverseur CMOS à la sortie des moyens commutateurs 460, en fonction du signal délivré par un autre inverseur 425, situé entre ce transistor interrupteur 424 et une sortie du décodeur 450.

**DOCUMENTS CITES :**

**Publications:**

[CHA'OI] : A. CHANDRAKASAN, et al., « Design of High-Performance Microprocessor Circuits », IEEE press, pp. 285-308, FOX 2001.

[KIM'05] : J.J. KIM, et al., « Back-Gate Controlled READ SRAM with Improved Stability », IEEE SOI CONFERENCE, pp. 211-212, Hawaii, USA, 2005.

[SEE'87] : E. SEEVINCK, et al., « Static-Noise Margin Analysis ofMOS SRAM Cells », IEEE JSSC, VOL. SC-22, No.5, October 1987.

[TAK'O 1] : K. Takeuchi, et al.,« A Study of Threshold Voltage Variation for Ultra SmallBulk and SOI CMOS », IEEE TED, VOL.48, No.9, September 2004.

[YAM'041] : M. YAMAOKA, et al., « Low Power SRAM Menu for SOC Application Using Yin-Yang-Feedback memory Ccli Technology », Symposium on VLSI circuits, Digest of Technical Papers, Honolulu, USA, June 2004.

**Revendications**

1.  Dispositif microélectronique de mémoire vive à accès aléatoire, comprenant une pluralité de cellules comportant respectivement :

    - une pluralité de transistors ($TL_T$, $TL_F$, $TD_T$, $TD_F$) formant un bistable,
    - un premier noeud de stockage (T) et un deuxième noeud de stockage (F),
    - un premier transistor ($TA_T$) double-grille d'accès au premier noeud de stockage et un deuxième transistor double-grille d'accès au deuxième noeud de stockage ($TA_F$), une première grille du premier transistor d'accès et une première grille du deuxième transistor d'accès étant reliées à une première ligne de mot ($WL_1$), une seconde grille du premier transistor d'accès et une seconde grille du deuxième transistor d'accès étant reliées à une deuxième ligne de mot ($WL_2$),

    la mémoire étant **caractérisée en ce qu'**elle est dotée en outre : d'une cellule mémoire de référence (CELL_REF) prévue pour délivrer un potentiel de polarisation (VWL2) destiné à être appliqué à l'une des lignes de mots ($WL_{21}$, ..., $WL_{2n}$) respective d'une ou plusieurs cellules données de ladite pluralité de cellules lors d'accès en lecture desdits cellules données, la valeur du potentiel de polarisation appliqué lors d'une opération de lecture étant comprise entre les valeurs de potentiels de polarisation appliqués lors des opérations de rétention et d'écriture de la cellule.

2. Dispositif microélectronique de mémoire vive à accès aléatoire selon la revendication 1, la cellule de référence comportant : un premier noeud de stockage (Tref) de référence et un deuxième noeud de stockage (Fref) de référence, ledit potentiel de polarisation (VWL2) délivré par la cellule mémoire de référence étant dépendant d'un potentiel de référence (VREF) prédéterminé.

3. Dispositif microélectronique de mémoire vive à accès aléatoire selon la revendication 1 ou 2, la cellule de référence comportant : un premier noeud de stockage (Tref) de référence et un deuxième noeud de stockage (Fref) de référence, ledit potentiel de polarisation (VWL2) délivré par la cellule mémoire de référence étant dépendant d'un potentiel de référence (VREF) prédéterminé et étant adapté en fonction des variations d'un potentiel du deuxième noeud (Fref) de référence de la cellule (CELL_REF) de référence.

4. Dispositif microélectronique de mémoire vive à accès aléatoire selon la revendication 3, la cellule de référence comportant : des moyens formant une boucle de rétroaction, prévus pour diminuer le potentiel du deuxième noeud (Fref) de référence de la cellule (CELL_REF) de référence suite à une augmentation de potentiel du deuxième noeud (Fref) de référence.

5. Dispositif microélectronique de mémoire vive à accès aléatoire selon la revendication 4, dans lequel la boucle de rétroaction est réalisée par des moyens formant un amplificateur opérationnel comportant :

   - une entrée inverseuse connectée au deuxième noeud (Fref) de la cellule de référence,
   - une entrée non-inverseuse à laquelle le potentiel prédéterminé de référence (Vref) est appliqué,
   - une sortie délivrant ledit potentiel de polarisation (VWL2).

6. Dispositif microélectronique de mémoire vive à accès aléatoire selon l'une des revendications 2 à 5, dans lequel la première ligne de mot est apte à être placée à une première valeur (VSS) de potentiel ou à une deuxième valeur (VDD) de potentiel, le potentiel de référence (VREF) étant prévu de sorte que le potentiel de polarisation (VWL2) est supérieur à la première valeur et inférieur à la deuxième valeur.

7. Dispositif microélectronique de mémoire vive à accès aléatoire selon l'une des revendications 1 à 6, la cellule de référence comportant en outre :

   - une pluralité de transistors ($ML_T$, $ML_F$, $MD_T$, $MD_F$) formant un bistable,
   - un premier transistor ($MA_T$) double-grille d'accès au premier noeud (Tref) de référence et un deuxième transistor double-grille d'accès ($MA_F$) au deuxième noeud (Fref) de référence,
   - une première grille du premier transistor d'accès et une première grille du deuxième transistor d'accès étant reliées à une première ligne de mot ($WL_{1REF}$), une seconde grille du premier transistor d'accès et une seconde grille du deuxième transistor d'accès étant reliées à une deuxième ligne de mot ($WL_{2REF}$) prévue pour délivrer ledit potentiel de polarisation (VWL2).

8. Dispositif microélectronique de mémoire vive à accès aléatoire selon la revendication 7, dans lequel la première ligne de mot ($WL_{1REF}$) de la cellule de référence est à un potentiel prévu pour assurer la conduction de transistors d'accès ($MA_F$, $MA_T$) de la cellule de référence (CELL_REF), le potentiel de polarisation donné (VWL2ref) étant acheminé par la deuxième ligne de mot ($WL_{2REF}$) de la cellule de référence (CELL_REF).

9. Dispositif microélectronique de mémoire vive à accès aléatoire selon l'une des revendications 1 à 8, la cellule de référence comportant une pluralité de transistors ayant un agencement identique à celui des transistors des cellules de ladite pluralité de cellules.

10. Dispositif microélectronique de mémoire vive à accès aléatoire selon l'une des revendications 1 à 9, comprenant en outre :

   - des premiers moyens de commutation aptes à placer la première ligne de mot d'une ou plusieurs cellules, à un premier potentiel (VSS) ou à un deuxième potentiel (VDD),
   - des deuxièmes moyens de commutation aptes à placer la deuxième ligne de mot ($WL_{21}$,...,$WL_{2n}$) d'une ou plusieurs cellules, audit premier potentiel ou audit potentiel de polarisation donné (VLW2ref).

11. Dispositif microélectronique de mémoire vive à accès aléatoire selon l'une des revendications 1 à 10, ledit potentiel de polarisation donné (VLW2ref) étant destiné à être appliqué à l'une des lignes de mot ($WL_{11}$, $WL_{21}$, $WL_{1n}$, $WL_{2n}$) respective d'une ou plusieurs cellules données de ladite pluralité de cellules lors d'accès en écriture desdites cellules données.

12. Dispositif microélectronique de mémoire vive à accès aléatoire selon l'une des revendications 1 à 10, dans lequel des potentiels de polarisation différents sont destinés à être appliqués à l'une des lignes de mot respective d'une ou plusieurs cellules données de ladite pluralité de cellules suivant que lesdites cellules données sont accédées en écriture, en lecture ou se trouvent en mode de rétention.

13. Dispositif microélectronique de mémoire vive à accès aléatoire selon la revendication 12, comprenant en outre :

   - des moyens pour placer la première ligne de mot d'une ou plusieurs cellules, à un premier potentiel ou à un deuxième potentiel,
   - des moyens pour placer la deuxième ligne de mot d'une ou plusieurs cellules, audit premier potentiel ou audit deuxième potentiel ou audit potentiel de polarisation donné.

**Claims**

1. Random access memory microelectronic device, comprising a plurality of cells comprising respectively:

   - a plurality of transistors ($TL_T$, $TL_F$, $TD_T$, $TD_F$) forming a bistable,
   - a first storage node (T) and a second storage node (F),
   - a first double gate access transistor ($TA_T$) to the first storage node and a second double gate access transistor to the second storage node ($TA_F$), a first gate of the first access transistor and a first gate of the second access transistor being linked to a first word line ($WL_1$), a second gate of the first access transistor and a second gate of the second access transistor being linked to a second word line ($WL_2$),

   the memory being **characterized in that** it is further equipped with: a reference memory cell (CELL_REF) provided to deliver a bias potential (VWL2) intended to be applied to one of the respective word lines ($WL_{21}$, ..., $WL_{2n}$) of one or several given cells of said plurality of cells during reading access of said given cells, the bias potential applied during a reading operation of the cell being within the range of bias potentials applied during retention and writing operations of the cell.

2. Random access memory microelectronic device according to claim 1, the reference cell comprising: a first reference storage node (Tref) and a second reference storage node (Fref), said bias potential (VWL2) delivered by the reference memory cell being dependent on a predetermined reference potential (VREF).

3. Random access memory microelectronic device according to claim 1 or 2, the reference cell comprising: a first reference storage node (Tref) and a second reference storage node (Fref), said bias potential (VWL2) delivered by the reference memory cell being dependent on a predetermined reference potential (VREF) and being adapted as a function of the variations in a potential of the second reference node (Fref) of the reference cell (CELL__REF).

4. Random access memory microelectronic device according to claim 3, the reference cell comprising: means forming a feedback loop, provided to reduce the potential of the second reference node (Fref) of the reference cell (CELL_REF) following an increase in potential of the second reference node (Fref).

5. Random access memory microelectronic device according to claim 4, in which the feedback loop is produced by means forming an operational amplifier comprising:

   - an inverting input connected to the second node (Fref) of the reference cell,
   - a non-inverting input to which the predetermined reference potential (Vref) is applied,
   - an output delivering said bias potential (VWL2).

6. Random access memory microelectronic device according to one of claims 2 to 5, in which the first word line is suited to be placed at a first potential value (VSS) or at a second potential value (VDD), the reference potential (VREF) being provided in such a way that the bias potential (VWL2) is greater than the first value and less than the second value.

7. Random access memory microelectronic device according to one of claims 1 to 6, the reference cell further comprising:

- a plurality of transistors ($ML_T$, $ML_F$, $MD_T$, $MD_F$) forming a bistable,
- a first double gate access transistor ($MA_T$) to the first reference node (Tref) and a second double gate access transistor ($MA_F$) to the second reference node(Fref),
- a first gate of the first access transistor and a first gate of the second access transistor being linked to a first word line ($WL_{1REF}$), a second gate of the first access transistor and a second gate of the second access transistor being linked to a second word line ($WL_{2REF}$) provided to deliver said bias potential (VWL2).

8. Random access memory microelectronic device according to claim 7, wherein the first word line ($WL_{1REF}$) of the reference cell is at a potential provided to assure the conduction of access transistors ($MA_F$, $MA_T$) of the reference cell (CELL_REF), the given bias potential (VWL2ref) being carried by the second word line ($WL_{2REF}$) of the reference cell (CELL_REF).

9. Random access memory microelectronic device according to one of claims 1 to 8, the reference cell comprising a plurality of transistors having an identical lay out to that of the transistors of the cells of said plurality of cells.

10. Random access memory microelectronic device according to one of claims 1 to 9, further comprising:

- first switching means suited to placing the first word line of one or several cells at a first potential (VSS) or at a second potential (VDD),
- second switching means suited to placing the second word line ($WL_{21}$, ..., $WL_{2n}$) of one or several cells at said first potential or at said given bias potential (VLW2ref).

11. Random access memory microelectronic device according to one of claims 1 to 10, said given bias potential (VLW2ref) being intended to be applied to one of the respective word lines ($WL_{11}$, $WL_{21}$, $WL_{1n}$, $WL_{2n}$) of one or several given cells of said plurality of cells during writing access of said given cells.

12. Random access memory microelectronic device according to one of claims 1 to 10, wherein different bias potentials are intended to be applied to one of the respective word lines of one or several given cells of said plurality of cells depending on whether said given cells are accessed in reading, writing or are in retention mode.

13. Random access memory microelectronic device according to claim 12, further comprising:

- means for placing the first word line of one or several cells at a first potential or at a second potential,
- means for placing the second word line of one or several cells at said first potential or at said second potential or at said given bias potential.

**Patentansprüche**

1. Mikroelektronische Arbeitsspeichervorrichtung mit zufälligem Zugriff, umfassend eine Mehrzahl von Zellen, die jeweils umfassen:

- eine Mehrzahl von Transistoren ($TL_T$, $TL_F$, $TD_T$, $TD_F$), die ein bistabiles Element bilden,
- einen ersten Speicherknoten (T) und einen zweiten Speicherknoten (F),
- einen ersten Doppelgatetransistor ($TA_T$) zum Zugriff auf den ersten Speicherknoten und einen zweiten Doppelgatetransistor zum Zugriff auf den zweiten Speicherknoten ($TA_F$), wobei ein erstes Gate des ersten Zugriffstransistors und ein erstes Gate des zweiten Zugriffstransistors mit einer ersten Wortleitung ($WL_1$) verbunden sind, wobei ein zweites Gate des ersten Zugriffstransistors und ein zweites Gate des zweiten Zugriffstransistors mit einer zweiten Wortleitung ($WL_2$) verbunden sind,

wobei der Speicher **dadurch** gekenntzeichnet ist, dass er ferner mit Folgendem ausgestattet ist: Mit einer Referenzspeicherzelle (CELL_REF), die dazu vorgesehen ist, ein Polarisationspotential (VWL2) zu liefern, das dazu ausgelegt ist, an eine jeweilige der Wortleitungen ($WL_{21}$, ..., $WL_{2n}$) einer oder mehrerer gegebener Zellen aus der Mehrzahl von Zellen während des Lesezugriffs der gegebenen Zellen angelegt zu werden, wobei der Wert des Polarisationspotentials, das während einer Leseoperation angelegt wird, zwischen den Polarisationspotentialwerten enthalten ist, die während der Rückhalte- und Schreiboperationen der Zelle angelegt werden.

2. Mikroelektronische Arbeitsspeichervorrichtung mit zufälligem Zugriff nach Anspruch 1, wobei die Referenzzelle Folgendes umfasst: Einen ersten Referenzspeicherknoten (Tref) und einen zweiten Referenzspeicherknoten (Fref), wobei das Polarisationspotential (VWL2), das von der Referenzspeicherzelle geliefert wird, von einem vorbestimmten Referenzpotential (VREF) abhängig ist.

3. Mikroelektronische Arbeitsspeichervorrichtung mit zufälligem Zugriff nach Anspruch 1 oder 2, wobei die Referenzzelle Folgendes umfasst: Einen ersten Referenzspeicherknoten (Tref) und einen zweiten Referenzspeicherknoten (Fref), wobei das Polarisationspotential (VWL2), das von der Referenzspeicherzelle geliefert wird, von einem vorbestimmten Referenzpotential abhängig ist und als Funktion der Variationen eines Potentials des zweiten Referenzknotens (Fref) der Referenzzelle (CELL_REF) angepasst ist.

4. Mikroelektronische Arbeitsspeichervorrichtung mit zufälligem Zugriff nach Anspruch 3, wobei die Referenzzelle Folgendes umfasst: Mittel, die eine Rückkopplungsschleife bilden und dazu vorgesehen sind, das Potential des zweiten Referenzknotens (Fref) der Referenzzelle (CELL_REF) im Anschluss an eine Erhöhung des Potentials des zweiten Referenzknotens (Fref) zu verringern.

5. Mikroelektronische Arbeitsspeichervorrichtung mit zufälligem Zugriff nach Anspruch 4, wobei die Rückkopplungsschleife durch Mittel realisiert ist, die einen Operationsverstärker bilden, umfassend:

   - einen invertierenden Eingang, der an den zweiten Knoten (Fref) der Referenzzelle angeschlossen ist,
   - einen nicht-invertierenden Eingang, an den das vorbestimmte Referenzpotential (Vref) angelegt ist,
   - einen Ausgang, der das Polarisationspotential (VWL2) liefert.

6. Mikroelektronische Arbeitsspeichervorrichtung mit zufälligem Zugriff nach einem der Ansprüche 2 bis 5, bei der die erste Fortleitung dazu ausgelegt ist, auf einen ersten Potentialwert (VSS) oder auf einen zweiten Potentialwert (VDD) gesetzt zu werden, wobei das Referenzpotential (VREF) derart vorgesehen ist, dass das Polarisationspotential (VWL2) größer ist als der erste Wert und kleiner als der zweite Wert.

7. Mikroelektronische Arbeitsspeichervorrichtung mit zufälligem Zugriff nach einem der Ansprüche 1 bis 6, wobei die Referenzzelle ferner Folgendes umfasst:

   - eine Mehrzahl von Transistoren ($ML_T$, $ML_F$, $MD_T$, $MD_F$), die ein bistabiles Element bilden,
   - einen ersten Doppelgatetransistor ($MA_T$) zum Zugriff auf den ersten Referenzknoten (Tref) und einen zweiten Doppelgatetransistor ($MA_F$) zum Zugriff auf den zweiten Referenzknoten (Fref),
   - wobei ein erstes Gate des ersten Zugriffstransistors und ein erstes Gate des zweiten Zugriffstransistors mit einer ersten Wortleitung ($WL_{1REF}$) verbunden sind, wobei ein zweites Gate des ersten Zugriffstransistors und ein zweites Gate des zweiten Zugriffstransistors mit einer zweiten Wortleitung ($WL_{2REF}$) verbunden sind, die dazu vorgesehen ist, das Polarisationspotential (VWL2) zu liefern.

8. Mikroelektronische Arbeitsspeichervorrichtung mit zufälligem Zugriff nach Anspruch 7, bei der die erste Wortleitung ($WL_{1REF}$) der Referenzzelle auf einem Potential ist, das dazu vorgesehen ist, die Leitung von Zugriffstransistoren ($MA_F$, $MA_T$) der Referenzzelle (CELL_REF) zu gewährleisten, wobei das gegebene Polarisationspotential (VWL2ref) durch die zweite Wortleitung ($WL_{2REF}$) der Referenzzelle (CELL_REF) geführt wird.

9. Mikroelektronische Arbeitsspeichervorrichtung mit zufälligem Zugriff nach einem der Ansprüche 1 bis 8, wobei die Referenzzelle eine Mehrzahl von Transistoren umfasst, die eine Gestaltung identisch zu jener der Transistoren der Zellen aus der Mehrzahl von Zellen haben.

10. Mikroelektronische Arbeitsspeichervorrichtung mit zufälligem Zugriff nach einem der Ansprüche 1 bis 9, ferner umfassend Folgendes:

   - erste Schaltermittel, die dazu ausgelegt sind, die erste Wortleitung einer oder mehrerer Zellen auf ein erstes Potential (VSS) oder auf ein zweites Potential (VDD) zu setzen,
   - zweite Schaltermittel, die dazu ausgelegt sind, die zweite Wortleitung ($WL_{21}$, ..., $WL_{2n}$) einer oder mehrerer

Zellen auf das erste Potential oder auf das gegebene Polarisationspotential (VLW2ref) zu setzen.

11. Mikroelektronische Arbeitsspeichervorrichtung mit zufälligem Zugriff nach einem der Ansprüche 1 bis 10, wobei das gegebene Polarisationspotential (VLW2ref) dazu ausgelegt ist, an eine jeweilige der Wortleitungen ($WL_{11}$, $WL_{21}$, $WL_{1N}$, $WL_{2N}$) einer oder mehrerer gegebener Zellen aus der Mehrzahl von Zellen während eines Schreibzugriffs der gegebenen Zellen angelegt zu sein.

12. Mikroelektronische Arbeitsspeichervorrichtung mit zufälligem Zugriff nach einem der Ansprüche 1 bis 10, bei der verschiedene Polarisationspotentiale dazu ausgelegt sind, an eine jeweilige der Wortleitungen einer oder mehrerer gegebener Zellen der Mehrzahl von Zellen angelegt zu sein, je nachdem, wie auf die gegebenen Zellen zum Schreiben oder zum Lesen zugegriffen wird, oder sie sich im Rückhaltemodus befinden.

13. Mikroelektronische Arbeitsspeichervorrichtung mit zufälligem Zugriff nach Anspruch 12, ferner umfassend Folgendes:

- Mittel zum Setzen der ersten Wortleitung einer oder mehrerer Zellen auf ein erstes Potential oder auf ein zweites Potential,
- Mittel zum Setzen der zweiten Wortleitung einer oder mehrerer Zellen auf das erste Potential oder auf das zweite Potential oder auf das gegebene Polarisationspotential.

FIG. 1

FIG. 2

FIG. 3

FIG. 4

FIG. 5

FIG. 6

# FIG. 7A

# FIG. 7B

FIG. 8

FIG. 9

## RÉFÉRENCES CITÉES DANS LA DESCRIPTION

**Documents brevets cités dans la description**

- FR 2898432

**Littérature non-brevet citée dans la description**

- **A. CHANDRAKASAN et al.** Design of High-Performance Microprocessor Circuits. IEEE press, 2001, 285-308
- **J.J. KIM et al.** Back-Gate Controlled READ SRAM with Improved Stability. *IEEE SOI CONFERENCE,* 2005, 211-212
- **E. SEEVINCK et al.** Static-Noise Margin Analysis of-MOS SRAM Cells. *IEEE JSSC,* Octobre 1987, vol. SC-22 (5
- **K. TAKEUCHI et al.** A Study of Threshold Voltage Variation for Ultra SmallBulk and SOI CMOS. *IEEE TED,* Septembre 2004, vol. 48 (9
- **M. YAMAOKA et al.** Low Power SRAM Menu for SOC Application Using Yin-Yang-Feedback memory Ccli Technology. *Symposium on VLSI circuits, Digest of Technical Papers,* Juin 2004